(19) Europäisches Patentamt
European Patent Office
Office européen des brevets

(11) EP 4 580 059 A1

(12) EUROPEAN PATENT APPLICATION
published in accordance with Art. 153(4) EPC

(43) Date of publication:
02.07.2025 Bulletin 2025/27

(51) International Patent Classification (IPC):
H03K 17/14 (2006.01)

(21) Application number: 23864521.2

(86) International application number:
PCT/CN2023/112355

(22) Date of filing: 10.08.2023

(87) International publication number:
WO 2024/055787 (21.03.2024 Gazette 2024/12)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 16.09.2022 CN 202211131954

(71) Applicant: Huawei Digital Power Technologies
Co., Ltd.
Shenzhen, Guangdong 518043 (CN)

(72) Inventors:
• MENG, Xiangfei
Shenzhen, Guangdong 518043 (CN)
• PENG, Junwei
Shenzhen, Guangdong 518043 (CN)
• WU, Hong
Shenzhen, Guangdong 518043 (CN)

(74) Representative: Maiwald GmbH
Engineering
Elisenhof
Elisenstrasse 3
80335 München (DE)

(54) **POWER DEVICE, ELECTRONIC DEVICE, AND CIRCUIT STRUCTURE**

(57) This application provides a power device, an electronic device, and a circuit structure. The power device includes a power element, a current sampling element, and a compensation element. The power element includes a first control end, a first electrode, and a second electrode. The current sampling element is configured to detect a current value between the first electrode and the second electrode of the power element. The current sampling element includes a second control end, a third electrode, and a fourth electrode. The second control end is connected to the first control end, the third electrode is connected to the first electrode, and the fourth electrode is connected to the second electrode via the compensation element. The current sampling element is connected in series to the compensation element, and a temperature coefficient of the current sampling element is opposite to that of the compensation element. The compensation element may compensate for a deviation between sampling values of the current sampling element at different temperatures, so that sampling values output by the current sampling element in sampling a same current at the different temperatures are the same or similar. This can reduce voltage stress of the power element generated when overcurrent protection or short-circuit protection is triggered, reduce a turn-off loss, and improve a current output capability of the power device.

FIG. 1

## Description

## CROSS-REFERENCE TO RELATED APPLICATIONS

This application claims priority to Chinese Patent Application No. 202211131954.7, filed with the China National Intellectual Property Administration on September 16, 2022 and entitled "POWER DEVICE, ELECTRONIC DEVICE, AND CIRCUIT STRUCTURE", which is incorporated herein by reference in its entirety.

## TECHNICAL FIELD

This application relates to the field of power electronics technologies, and in particular, to a power device, an electronic device, and a circuit structure.

## BACKGROUND

With development of power electronics technologies, power devices like an insulated gate bipolar transistor (IGBT) have been widely used in various fields. In a high-power application scenario, especially in a scenario with a high security requirement, such as an electric vehicle, to prevent the power devices like the IGBT from generating excessive voltage stress or being secondarily damaged when an exception such as an overcurrent or a short circuit occurs, overcurrent protection and short-circuit protection are usually performed on the power devices like the IGBT.

In the conventional technology, a part of a cell region in an IGBT chip may be used as an IGBT, and the other part of the cell region may be used as a current sensor. The current sensor may sample a current of the IGBT based on a specific ratio, to obtain a current of the IGBT based on a sampling value of the current sensor. A drive chip may determine, based on the sampling value of the current sensor, whether an overcurrent or a short circuit occurs in the IGBT. When the overcurrent or the short circuit occurs in the IGBT, the drive chip may trigger a protection operation such as soft shutdown or stopping sending a PWM driver gating signal.

However, a deviation between sampling values output by the current sensor in sampling a same current at different temperatures is large. Usually, a deviation between sampling values of the current sensor at a high temperature and a normal temperature is at least 30%. Generally, a sampling value of the current sensor at a low temperature is large. To prevent an overcurrent protection operation or a short-circuit protection operation from being triggered by mistake at the low temperature, thresholds for triggering overcurrent protection and short-circuit protection in the drive chip need to be set to be larger. As a result, a current value of the IGBT is large when overcurrent protection or short-circuit protection is triggered. In addition, to prevent excessive voltage stress of the IGBT from being generated when overcurrent protection or short-circuit protection is triggered, a larger turn-off resistance or gate capacitance needs to be set, resulting in a larger turn-off loss and a low current output capability of the power device.

## SUMMARY

Embodiments of this application provide a power device, an electronic device, and a circuit structure, to resolve a problem that a current output capability of the power device is low because a deviation between sampling values output by a current sensor in sampling a same current at different temperatures is large.

According to a first aspect, an embodiment of this application provides a power device. The power device may include a power element, a current sampling element, and a compensation element. The power element includes a first control end, a first electrode, and a second electrode. The current sampling element is configured to detect a current value between the first electrode and the second electrode of the power element. The current sampling element is connected in series to the compensation element, and a temperature coefficient of the current sampling element is opposite to that of the compensation element. The current sampling element may include a second control end, a third electrode, and a fourth electrode. Conduction and cutoff between the third electrode and the fourth electrode may be controlled based on a level of the second control end, and the second control end is connected to the first control end, so that the current sampling element and the power element can be synchronously conducted and cut off. The third electrode is connected to the first electrode, and the fourth electrode is connected to the second electrode via the compensation element.

In the power device provided in this embodiment of this application, the compensation element connected in series to the current sampling element is disposed, the temperature coefficient of the current sampling element is opposite to that of the compensation element, and the compensation element may compensate for a deviation between sampling values of the current sampling element at different temperatures, so that sampling values output by the current sampling element in sampling a same current at the different temperatures are the same or similar, and threshold currents of the power element used when overcurrent protection or short-circuit protection is triggered at the different temperatures are the same or similar. This can prevent an overcurrent protection operation or a short-circuit protection operation from being triggered by mistake at a low temperature, can reduce a trigger threshold in a drive chip, and can reduce a current value of the power element used when overcurrent protection or short-circuit protection is triggered, thereby reducing voltage stress of the power element generated when overcurrent protection or short-circuit protection is triggered, reducing a turn-off resistance or a gate capacitance, reducing a turn-off loss, and improving a current output capability of the power device.

In this embodiment of this application, "same or similar" may be understood as that a difference between the two is less than or equal to 10%. For example, that the sampling values output by the current sampling element in sampling the same current at the different temperatures are the same or similar may be understood as follows: A difference between the sampling values output by the current sampling element in sampling the same current at the different temperatures is less than or equal to 20%. For another example, that the threshold currents of the power element used when overcurrent protection or short-circuit protection is triggered at the different temperatures are the same or similar may be understood as follows: A difference between the threshold currents of the power element used when overcurrent protection is triggered at the different temperatures is less than or equal to 20%, and a difference between the threshold currents of the power element used when short-circuit protection is triggered at the different temperatures is less than or equal to 20%.

In some embodiments of this application, the power element may include an insulated gate bipolar transistor (IGBT). The first control end may be a gate, the first electrode may be a collector, and the second electrode may be an emitter. Alternatively, the power element may include a metal-oxide semiconductor field-effect transistor (MOSFET). The first control end may be a gate, the first electrode may be a source, and the second electrode may be a drain. In this embodiment of this application, the MOSFET may be a silicon (Si)-based MOSFET, or the MOSFET may be a silicon carbide (SiC)-based MOSFET. Certainly, the power element in this embodiment of this application may alternatively include another switch element. This is not limited herein.

In some embodiments of this application, the current sampling element may have a positive temperature coefficient, and the compensation element may have a negative temperature coefficient. The current sampling element has a positive temperature coefficient when a current is small, or has a negative temperature coefficient when a current is large. In an application scenario in this embodiment of this application, a current of the current sampling element is small. Therefore, in this embodiment of this application, an example in which the current sampling element has a positive temperature coefficient is used for description. In another scenario, if the current sampling element has a negative temperature coefficient, the compensation element may be set to having a positive temperature coefficient. In this embodiment of this application, that the current sampling element has the positive temperature coefficient means that a sampling voltage of the current sampling element increases as a temperature increases, and that the compensation element has the negative temperature coefficient means that a sampling voltage of the compensation element decreases as a temperature increases.

In a possible implementation, a specific proportion of a cell region in the power device may be used as a current mirror, to sample a current of the power element, that is, the cell region in the power device may be divided into a first sub-cell region and a second sub-cell region, the first sub-cell region may be used as the power element, and the second sub-cell region may be used as the current sampling element. In other words, the current sampling element may be a switch element of a same type as the power element. For example, when the power element is an IGBT, the current sampling element may be an IGBT. For another example, when the power element is a MOSFET, the current sampling element may be a MOSFET. In actual application, the power element and the current sampling element may be integrated into a same wafer. This can reduce complexity of a manufacturing process, and can improve integration of the power device.

During specific implementation, a specific proportion of a cell region in the power device may be used as the current sampling element, and the current sampling element may perform sampling on the power element based on a specified ratio. Therefore, a current value of the power element may be obtained based on a sampling value of the current sampling element and the specified ratio. A ratio of a current allocated to the power element to a current allocated to the current sampling element (namely, the foregoing specified ratio) may be predetermined based on a factor such as a cell region allocation proportion in the power device. For example, a ratio of the current allocated to the current sampling element to the current allocated the power element may be about 1: 1000. Based on the allocation ratio, a part of an input current is input to the power element, and the other part of the input current is input to the current sampling element. A current of the power element and a current of the current sampling element meet the foregoing current allocation ratio, so that the current of the power element can be obtained based on the current of the current sampling element. In actual application, a sampling resistor may be connected in series to the fourth electrode of the current sampling element, to convert a current signal into a voltage signal. The current of the power element may be indirectly obtained based on a voltage of the sampling resistor. In other words, in this embodiment of this application, the sampling value output by the current sampling element may be the voltage of the sampling resistor. Certainly, in some cases, the sampling value output by the current sampling element may alternatively be a current or another parameter. This is not limited herein.

The power device in this embodiment of this application is used in an electronic device. The drive chip in the electronic device may obtain the voltage at two ends of the sampling resistor, determine, based on the voltage, whether a fault such as an overcurrent or a short circuit occurs, and trigger, based on a fault type, a protection operation such as soft shutdown or stopping sending a PWM driver gating signal. During specific implementation, the trigger threshold in the drive chip may be classified into a first threshold and a second threshold. The first threshold is used to trigger overcurrent protection, and the second threshold is used to trigger short-circuit protection. Generally, the first threshold is less than the second threshold. The drive chip may compare the sampling value output by the current sampling element with the first threshold and the second threshold. When the sampling value is greater than the first threshold and less than the second threshold, the drive chip may trigger overcurrent protection such as stopping sending the PWM driver gating signal. When the sampling value is greater than the second threshold, the drive chip may trigger short-circuit protection such as soft shutdown.

In a possible implementation, the power device may include one compensation element. In another possible implementation, the power device may include at least two compensation elements connected in series and/or in parallel. For example, the power device may include two compensation elements connected in parallel. During specific implementation, a plurality of compensation elements may be disposed in the power device. The compensation elements may be first connected in parallel and then connected in series, or may be first connected in series and then connected in parallel. A connection line for the compensation elements in the power device is not limited herein. When a structure of the power device is specifically set, a connection relationship between the compensation elements may be set based on an actual requirement.

In some embodiments of this application, the power element, the current sampling element, and the compensation element may be located in a same wafer. Therefore, the power element, the current sampling element, and the compensation element are located in a same temperature field, the compensation element can sense a temperature change of the power element, and the compensation element may adaptively adjust, with the temperature change, the sampling value output by the current sampling element, to compensate for the sampling value output by the current sampling element, so that the sampling value output by the current sampling element in sampling the same current does not change with the temperature change or changes with the temperature change in a small amplitude. This improves precision of the current sampling element. When layout of various components in the wafer is specifically set, a location of the compensation element may be set as close as possible to a location of the power element, so that a temperature of the location of the compensation element is basically the same as a temperature of the location of the power element. In addition, the power element, the current sampling element, and the compensation element are disposed in the same wafer. This can reduce complexity of a manufacturing process, and can improve integration of the power device.

In some other embodiments of this application, the power element and the current sampling element are located in a same wafer, the compensation element is located at a location outside the wafer, and the compensation element is located on a side that is of the power element and that is close to the first control end. During specific implementation, the compensation element may be disposed in a wafer other than the wafer in which the power element is located, or the compensation element may be an element that does not need to be disposed in a wafer. Therefore, the power element, the current sampling element, and the compensation element may be located in a same temperature field, the compensation element can sense a temperature change of the power element, and the compensation element may adaptively adjust, with the temperature change, the sampling value output by the current sampling element, to compensate for the sampling value output by the current sampling element, so that the sampling value output by the current sampling element in sampling the same current does not change with the temperature change or changes with the temperature change in a small amount. When a location of the compensation element is specifically set, the location of the compensation element may be set as close as possible to a location of the power element, so that a temperature of the location of the compensation element is basically the same as a temperature of the location of the power element. In addition, the power element and the current sampling element are disposed in the same wafer. This can reduce complexity of a manufacturing process, and can improve integration of the power device.

In this embodiment of this application, there are a plurality of implementations for the compensation element. Examples of several implementations for the compensation element are described below.

Implementation 1

The compensation element may include a diode, an anode of the diode is connected to the fourth electrode of the current sampling element, and a cathode of the diode is connected to the second electrode of the power element. In this embodiment of this application, the current sampling element has the positive temperature coefficient, and the diode may have the negative temperature coefficient. Therefore, the diode may compensate for the deviation between the sampling values of the current sampling element at the different temperatures, so that the sampling values output by the current sampling element in sampling the same current at the different temperatures are the same or similar.

Implementation 2

The compensation element may include a resistor, one end of the resistor is connected to the fourth electrode of the current sampling element, and the other end of the resistor is connected to the second electrode of the power element. In this embodiment of this application, the current sampling element has the positive temperature coefficient, and the resistor may have the negative temperature coefficient. Therefore, the resistor may compensate for the deviation between the sampling values of the current sampling element at the different temperatures, so that the sampling values output by the current sampling element in sampling the same current at the different temperatures are the same or similar.

Implementation 3

The compensation element may include a triode, the triode may include a third control end, a fifth electrode, and a sixth electrode, the third control end of the triode is connected to the fifth electrode or the sixth electrode, the fifth electrode of the triode is connected to the fourth electrode of the current sampling element, and the sixth electrode of the triode is connected to the second electrode of the power element.

In actual application, the triode may be a PNP transistor, and the third control end may be connected to the sixth electrode, so that the triode is equivalent to a diode. Alternatively, the triode may be an NPN transistor, and the third control end may be connected to the fifth electrode, so that the triode is equivalent to a diode. During specific implementation, the power device may include only one triode, or may include two or more triodes; and may include only one type of transistor, or may include two types of transistors. A quantity and a type of triodes are not limited herein.

In this embodiment of this application, the current sampling element has the positive temperature coefficient, and the triode may have the negative temperature coefficient by using a carrier life control method. Therefore, the triode may compensate for the deviation between the sampling values of the current sampling element at the different temperatures, so that the sampling values output by the current sampling element in sampling the same current at the different temperatures are the same or similar.

For example, the triode may be a bipolar junction transistor (BJT). Certainly, the triode may alternatively be another triode having a negative temperature coefficient. This is not limited herein.

Several implementations for the compensation element are described above. During specific implementation, the several implementations may be combined, that is, the power device may include different types of compensation elements. For example, the power device may include the diode and the triode. In some embodiments, in addition to the several implementations described above, the compensation element may also be another element whose temperature coefficient is opposite to that of the current sampling element. This is not limited herein.

In this embodiment of this application, the compensation element in the power device may be disposed only inside the wafer. Alternatively, the compensation element in the power device may be disposed only outside the wafer. Alternatively, when the power device includes at least two compensation elements, the compensation elements may be disposed respectively inside and outside the wafer. During specific implementation, a quantity and locations of compensation elements may be set based on internal spatial layout and a compensation requirement of the power device. This is not limited herein.

According to a second aspect, an embodiment of this application further provides an electronic device. The electronic device may include any one of the foregoing power devices and a drive chip. The drive chip is configured to: receive a sampling value output by a current sampling element, and perform a corresponding protection operation when the sampling value exceeds a specified threshold.

The electronic device may be used in a vehicle such as an electric vehicle, or the electronic device may be used in a scenario with a high-power requirement, such as a photovoltaic charging station, a charging station, or a charging pile. In addition, the electronic device may be another device including a power device. This is not limited herein. For example, the electronic device in this embodiment of this application may be a power module, and the power may include any one of the foregoing power devices, a peripheral drive chip, a heat dissipation device, a package device, and the like.

A compensation element connected in series to the current sampling element is disposed in the foregoing power device, a temperature coefficient of the current sampling element is opposite to that of the compensation element, and the compensation element may compensate for a deviation between sampling values of the current sampling element at different temperatures, so that sampling values output by the current sampling element in sampling a same current at the different temperatures are the same or similar, and precision of the sampling values output by the current sampling element is high. In addition, threshold currents of a power element used when overcurrent protection or short-circuit protection is triggered at different temperatures are the same or similar, and a large trigger threshold does not need to be set in the drive chip. This can prevent an overcurrent protection operation or a short-circuit protection operation from being triggered by mistake at a low temperature, and can reduce a current value of the power element used when overcurrent protection or short-circuit protection is triggered, thereby reducing voltage stress of the power element generated when overcurrent protection or short-circuit protection is triggered, reducing a turn-off resistance or a gate capacitance, reducing a turn-off loss, and improving a current output capability of the power device.

During specific implementation, a trigger threshold in the drive chip may be classified into a first threshold and a second threshold. The first threshold is used to trigger overcurrent protection, and the second threshold is used to trigger short-circuit protection. Generally, the first threshold is less than the second threshold. The drive chip may compare the sampling value output by the current sampling element with the first threshold and the second threshold. When the sampling value is greater than the first threshold and less than the second threshold, the drive chip may trigger overcurrent protection such as stopping sending a PWM driver gating signal. When the sampling value is greater than the second threshold, the drive chip may trigger short-circuit protection such as soft shutdown.

According to a third aspect, an embodiment of this application further provides a circuit structure. The circuit structure may be used in a power electronic device with a high-power requirement, such as a vehicle-mounted inverter or a photovoltaic inverter. The circuit structure may include at least one bridge arm, a controller, and a first output end, the at least one bridge arm may include an upper bridge arm and a lower bridge arm, the upper bridge arm may include at least one first power device, the lower bridge arm may include at least one second power device, and the first power device and the second power device each are any power device in the first aspect. The first power device may include a first power element, a first current sampling element, and a first compensation element, the first current sampling element is connected in series to the first compensation element, and the first compensation element may compensate for a deviation between sampling values of the first current sampling element at different temperatures, so that sampling values output by the first current sampling element in sampling a same current at the different temperatures are the same or similar. The second power device may include a second power element, a second current sampling element, and a second compensation element. The second current sampling element is connected in series to the second compensation element, and the second compensation element may compensate for a deviation between sampling values of the second current sampling element at different temperatures, so that sampling values output by the second current sampling element in sampling a same current at the different temperatures are the same or similar. That is, current sampling precision of the first current sampling element and the second current sampling element in this embodiment of this application is high.

The first power element and the second power element are separately connected to the first output end, the first current sampling element and the second current sampling element are separately connected to the controller, and the controller is configured to determine a current value and phase information of the first output end based on first sampling information output by the first current sampling element and second sampling information output by the second current sampling element. The first sampling information may include a sampling value, the second sampling information may include a sampling value, and the sampling value may be a voltage of a sampling resistor, or may be another parameter.

In the conventional technology, a Hall current sensor is usually connected to a first output end, to detect a current value and phase information of the first output end. However, the Hall current sensor has a large volume, and a response speed of the Hall current sensor is low, and is generally about 10 μs. In this embodiment of this application, the current value and the phase information of the first output end may be determined based on the first sampling information output by the first current sampling element and the second sampling information output by the second current sampling element, to replace a function of the Hall current sensor in the conventional technology, that is, the Hall current sensor does not need to be disposed at the first output end. This can simplify the circuit structure, reduce an overall volume of the circuit structure, and increase power density. In addition, in this embodiment of this application, a response speed for detecting a current by the current sampling element is high. For example, the response speed may be less than 1 μs. This can effectively increase the response speed for current detection, and improve performance of the circuit structure.

## BRIEF DESCRIPTION OF DRAWINGS

FIG. 1 is a diagram of a structure of a power device according to an embodiment of this application;

FIG. 2 is a diagram of an equivalent structure of the power device shown in FIG. 1;

FIG. 3 is a diagram of a sampling principle of a current sampling element according to an embodiment of this application;

FIG. 4 is a diagram of another structure of a power device according to an embodiment of this application;

FIG. 5 is a diagram of another structure of a power device according to an embodiment of this application;

FIG. 6 is a diagram of another structure of a power device according to an embodiment of this application;

FIG. 7 is a diagram of another structure of a power device according to an embodiment of this application;

FIG. 8 is a diagram of another structure of a power device according to an embodiment of this application;

FIG. 9 is a diagram of another structure of a power device according to an embodiment of this application;

FIG. 10 is a diagram of another structure of a power device according to an embodiment of this application;

FIG. 11 is a diagram of another structure of a power device according to an embodiment of this application;

FIG. 12 is a diagram of another structure of a power device according to an embodiment of this application; and

FIG. 13 is a schematic of a circuit structure according to an embodiment of this application.

Reference numerals:

10: wafer; 11: power element; 11a: first power element; 11b: second power element; 12: current sampling element; 12a: first current sampling element; 12b: second current sampling element; 13: compensation element; 131: diode; 132: resistor; 133: triode; 21: first power device; 22: second power device; 23: controller; 24: isolation device; 25: first protection device; 26: second protection device; G1: first control end; G2: second control end; G3: third control end; T1: first electrode; T2: second electrode; T3: third electrode; T4: fourth electrode; T5: fifth electrode; T6: sixth electrode; Rs: sampling resistor; and U: first output end.

**DESCRIPTION OF EMBODIMENTS**

To make the objectives, technical solutions, and advantages of this application clearer, the following further describes this application in detail with reference to accompanying drawings.

It should be noted that identical reference numerals in the accompanying drawings of this application denote identical or similar structures. Therefore, repeated description thereof is omitted. Expressions of locations and directions in this application are described by using the accompanying drawings as examples. However, changes may also be made as required, and all the changes fall within the protection scope of this application. The accompanying drawings in this application are merely used to illustrate a relative location relationship and do not represent an actual ratio.

Embodiments of this application provide a power device, an electronic device, and a circuit structure, to resolve a problem that a current output capability of the power device is low because a deviation between sampling values output by a current sensor in sampling a same current at different temperatures is large. The electronic device may be used in a vehicle such as an electric vehicle, or the electronic device may be used in a scenario with a high-power requirement, such as a photovoltaic charging station, a charging station, or a charging pile. In addition, the electronic device may be another device including a power device. This is not limited herein.

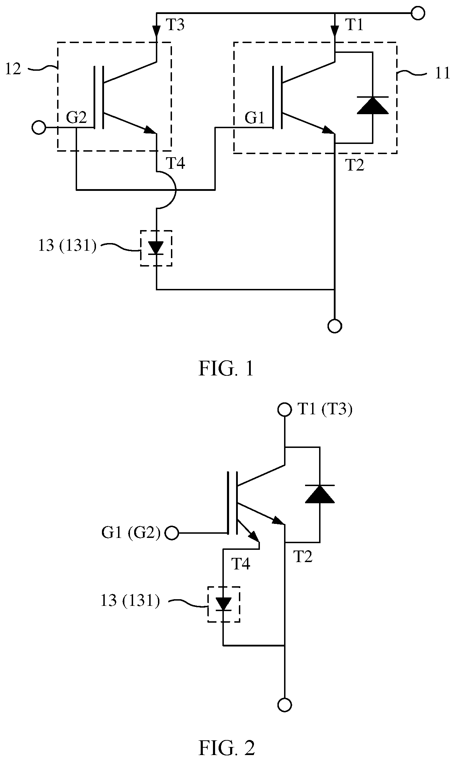

FIG. 1 is a diagram of a structure of a power device according to an embodiment of this application. As shown in FIG. 1, the power device in this embodiment of this application may include a power element 11, a current sampling element 12, and a compensation element 13. The power element 11 includes a first control end G1, a first electrode T1, and a second electrode T2. The current sampling element 12 is configured to detect a current value between the first electrode T1 and the second electrode T2 of the power element 11. The current sampling element 12 is connected in series to the compensation element 13, and a temperature coefficient of the current sampling element 12 is opposite to that of the compensation element 13.

In the power device provided in this embodiment of this application, the compensation element connected in series to the current sampling element is disposed, the temperature coefficient of the current sampling element is opposite to that of the compensation element, and the compensation element may compensate for a deviation between sampling values of the current sampling element at different temperatures, so that sampling values output by the current sampling element in sampling a same current at the different temperatures are the same or similar, and threshold currents of the power element used when overcurrent protection or short-circuit protection is triggered at the different temperatures are the same or similar. This can prevent an overcurrent protection operation or a short-circuit protection operation from being triggered by mistake at a low temperature, can reduce a trigger threshold in a drive chip, and can reduce a current value of the power element used when overcurrent protection or short-circuit protection is triggered, thereby reducing voltage stress of the power element generated when overcurrent protection or short-circuit protection is triggered, reducing a turn-off resistance or a gate capacitance, reducing a turn-off loss, and improving a current output capability of the power device.

In this embodiment of this application, "same or similar" may be understood as that a difference between the two is less than or equal to 10%. For example, that the sampling values output by the current sampling element in sampling the same current at the different temperatures are the same or similar may be understood as follows: A difference between the sampling values output by the current sampling element in sampling the same current at the different temperatures is less than or equal to 20%. For another example, that the threshold currents of the power element used when overcurrent protection or short-circuit protection is triggered at the different temperatures are the same or similar may be understood as follows: A difference between the threshold currents of the power element used when overcurrent protection is triggered at the different temperatures is less than or equal to 20%, and a difference between the threshold currents of the power element used when short-circuit protection is triggered at the different temperatures is less than or equal to 20%.

In some embodiments of this application, the power element 11 may include an insulated gate bipolar transistor (IGBT). The first control end G1 may be a gate, the first electrode T1 may be a collector, and the second electrode T2 may be an emitter. Alternatively, the power element 11 may include a metal-oxide semiconductor field-effect transistor (MOSFET). The first control end G1 may be a gate, the first electrode T1 may be a source, and the second electrode T2 may be a drain. In this embodiment of this application, the MOSFET may be a silicon (Si)-based MOSFET, or the MOSFET may be a silicon carbide (SiC)-based MOSFET. Certainly, the power element 11 in this embodiment of this application may alternatively include another switch element. This is not limited herein.

In some embodiments of this application, the current sampling element may have a positive temperature coefficient, and the compensation element may have a negative temperature coefficient. The current sampling element has a positive temperature coefficient when a current is small, or has a negative temperature coefficient when a current is large. In an application scenario in this embodiment of this application, a current of the current sampling element is small. Therefore, in this embodiment of this application, an example in which the current sampling element has a positive temperature coefficient is used for description. In another scenario, if the current sampling element has a negative temperature coefficient, the compensation element may be set to having a positive temperature coefficient. In this embodiment of this application, that the current sampling element has the positive temperature coefficient means that a sampling voltage of the current sampling element increases as a temperature increases, and that the compensation element has the negative temperature coefficient means that a sampling voltage of the compensation element decreases as a temperature increases.

FIG. 2 is a diagram of an equivalent structure of the power device shown in FIG. 1. With reference to FIG. 1 and FIG. 2, in some embodiments of this application, the current sampling element 12 may include a second control end G2, a third electrode T3, and a fourth electrode T4. Conduction and cutoff between the third electrode T3 and the fourth electrode T4 may be controlled based on a level of the second control end G2, and the second control end G2 is connected to the first control end G1, so that the current sampling element 12 and the power element 11 can be synchronously conducted and cut off. The third electrode T3 is connected to the first electrode T1, and the fourth electrode T4 is connected to the second electrode T2 via the compensation element 13. During specific implementation, a ratio of a current allocated to the current sampling element 12 to a current allocated to the power element 11 may be predetermined, and the current sampling element 12 may sample a current value of the power element 11 based on a specific ratio. Therefore, the current value of the power element 11 may be obtained based on the sampling value of the current sampling element 12.

In a possible implementation, a specific proportion of a cell region in the power device may be used as a current mirror, to sample a current of the power element 11, that is, the cell region in the power device may be divided into a first sub-cell region and a second sub-cell region, the first sub-cell region may be used as the power element 11, and the second sub-cell region may be used as the current sampling element 12. In other words, the current sampling element 12 may be a switch element of a same type as the power element 11. For example, when the power element 11 is an IGBT, the current sampling element 12 may be an IGBT. For another example, when the power element 11 is a MOSFET, the current sampling element 12 may be a MOSFET. In actual application, the power element 11 and the current sampling element 12 may be integrated into a same wafer. This can reduce complexity of a manufacturing process, and can improve integration of the power device.

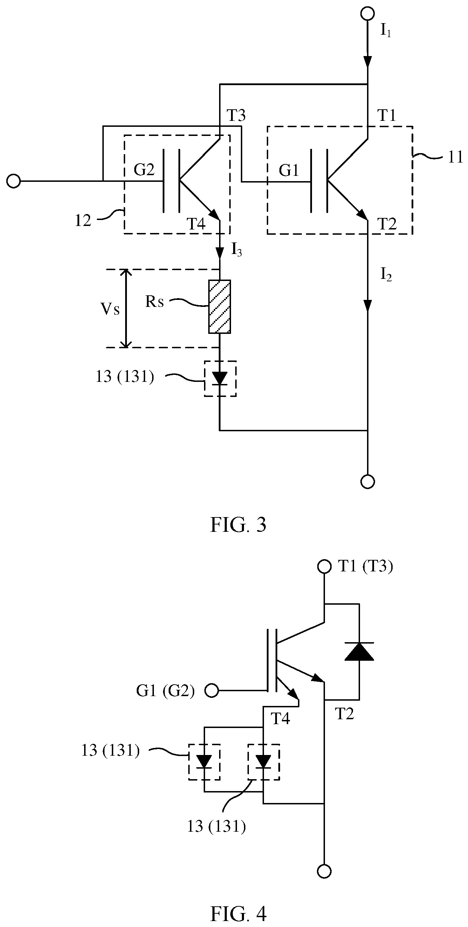

FIG. 3 is a diagram of a sampling principle of the current sampling element according to this embodiment of this application. As shown in FIG. 3, a specific proportion of a cell region in the power device may be used as the current sampling element 12, and the current sampling element may perform sampling on the power element based on a specified ratio. Therefore, a current value of the power element may be obtained based on a sampling value of the current sampling element and the specified ratio. A ratio of a current allocated to the power element 11 to a current allocated to the current sampling element 12 (namely, the foregoing specified ratio) may be predetermined based on a factor such as a cell region allocation proportion in the power device. For example, a ratio of the current allocated to the current sampling element 12 to the current allocated the power element 11 may be about 1: 1000. Based on the allocation ratio, a part of an input current I1 is input to the power element 11, and the other part of the input current I1 is input to the current sampling element 12. A current I2 of the power element 11 and a current I3 of the current sampling element 12 meet the foregoing current allocation ratio, so that the current I2 of the power element 11 can be obtained based on the current I3 of the current sampling element 12. In actual application, a sampling resistor Rs may be connected in series to the fourth electrode T4 of the current sampling element 12, to convert a current signal into a voltage signal. The current I2 of the power element 11 may be indirectly obtained based on a voltage Vs of the sampling resistor Rs. In other words, in this embodiment of this application, the sampling value output by the current sampling element 12 may be the voltage of the sampling resistor Rs. Certainly, in some cases, the sampling value output by the current sampling element 12 may alternatively be a current or another parameter. This is not limited herein.

For example, the current I2 of the power element 11 may be determined according to the following formula:

$$I_2 = k * \frac{V_S}{R_s} + \frac{V_S}{R}$$

k indicates a current allocation ratio of the current sampling element 12, Rs indicates a resistance of the sampling resistor, Vs indicates a voltage at two ends of the sampling resistor Rs, and R indicates equivalent slope resistances at different temperatures.

The power device in this embodiment of this application is used in an electronic device. The drive chip in the electronic device may obtain the voltage Vs at the two ends of the sampling resistor Rs, determine, based on the voltage Vs, whether a fault such as an overcurrent or a short circuit occurs, and trigger, based on a fault type, a protection operation such as soft shutdown or stopping sending a PWM driver gating signal. During specific implementation, a trigger threshold in the drive chip may be classified into a first threshold and a second threshold. The first threshold is used to trigger overcurrent protection, and the second threshold is used to trigger short-circuit protection. Generally, the first threshold is less than the second threshold. The drive chip may compare the sampling value output by the current sampling element with the first threshold and the second threshold. When the sampling value is greater than the first threshold and less than the second threshold, the drive chip may trigger overcurrent protection such as stopping sending the PWM driver gating signal. When the sampling value is greater than the second threshold, the drive chip may trigger short-circuit protection such as soft shutdown.

As shown in FIG. 1, in a possible implementation, the power device may include one compensation element 13. In another possible implementation, the power device may include at least two compensation elements connected in series and/or in parallel. FIG. 4 is a diagram of another structure of the power device according to this embodiment of this application. For example, the power device shown in FIG. 4 includes two compensation elements 13 connected in parallel. During specific implementation, a plurality of compensation elements may be disposed in the power device. The compensation elements may be first connected in parallel and then connected in series, or may be first connected in series and then connected in parallel. A connection line for the compensation elements in the power device is not limited herein. When the structure of the power device is specifically set, a connection relationship between the compensation elements may be set based on an actual requirement.

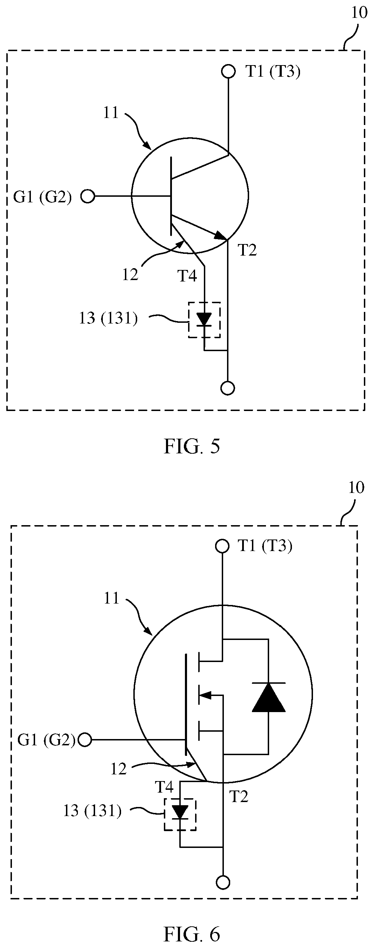

FIG. 5 is a diagram of another structure of the power device according to this embodiment of this application. In FIG. 5, an example in which the power element is an IGBT is used for illustration. FIG. 6 is a diagram of another structure of the power device according to this embodiment of this application. In FIG. 6, an example in which the power element is a MOSFET is used for illustration. As shown in FIG. 5 and FIG. 6, in some embodiments of this application, the power element 11, the current sampling element 12, and the compensation element 13 may be located in a same wafer 10. Therefore, the power element 11, the current sampling element 12, and the compensation element 13 are located in a same temperature field, the compensation element 13 can sense a temperature change of the power element 11, and the compensation element 13 may adaptively adjust, with the temperature change, the sampling value output by the current sampling element 12, to compensate for the sampling value output by the current sampling element 12, so that the sampling value output by the current sampling element 12 in sampling the same current does not change with the temperature change or changes with the temperature change in a small amplitude. This improves precision of the current sampling element 12. When layout of various components in the wafer 10 is specifically set, a location of the compensation element 13 may be set as close as possible to a location of the power element 11, so that a temperature of the location of the compensation element 13 is basically the same as a temperature of the location of the power element 11. In addition, the power element 11, the current sampling element 12, and the compensation element 13 are disposed in the same wafer 10. This can reduce complexity of a manufacturing process, and can improve integration of the power device.

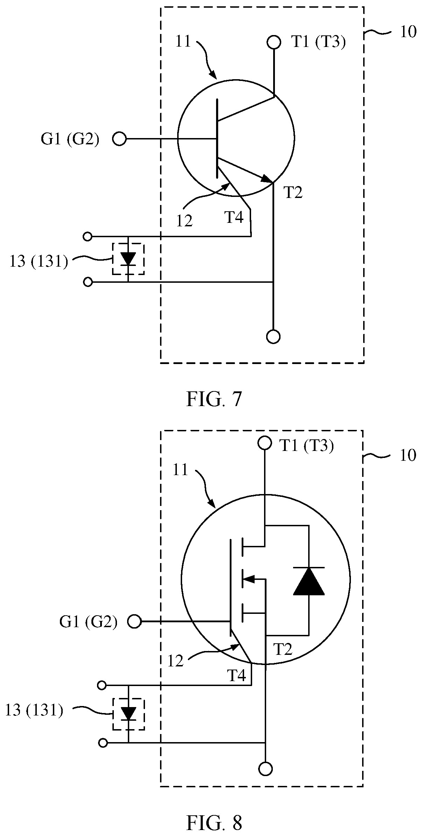

FIG. 7 is a diagram of another structure of the power device according to this embodiment of this application. In FIG. 7, an example in which the power element is an IGBT is used for illustration. FIG. 8 is a diagram of another structure of the power device according to this embodiment of this application. In FIG. 8, an example in which the power element is a MOSFET is used for illustration. As shown in FIG. 7 and FIG. 8, in some other embodiments of this application, the power element 11 and the current sampling element 12 are located in a same wafer 10, the compensation element 13 is located at a location outside the wafer 10, and the compensation element 13 is located on a side that is of the power element 11 and that is close to the first control end G1. During specific implementation, the compensation element 13 may be disposed in a wafer other than the wafer 10 in which the power element 11 is located, or the compensation element 13 may be an element that does not need to be disposed in a wafer. Therefore, the power element 11, the current sampling element 12, and the compensation element 13 may be located in a same temperature field, the compensation element 13 can sense a temperature change of the power element 11, and the compensation element 13 may adaptively adjust, with the temperature change, the sampling value output by the current sampling element 12, to compensate for the sampling value output by the current sampling element 12, so that the sampling value output by the current sampling element 12 in sampling the same current does not change with the temperature change or changes with the temperature change in a small amount. When a location of the compensation element 13 is specifically set, the location of the compensation element 13 may be set as close as possible to a location of the power element 11, so that a temperature of the location of the compensation element 13 is basically the same as a temperature of the location of the power element 11. In addition, the power element 11 and the current sampling element 12 are disposed in the same wafer 10. This can reduce complexity of a manufacturing process, and can improve integration of the power device.

In this embodiment of this application, there are a plurality of implementations for the compensation element. Examples of several implementations for the compensation element are described below with reference to accompanying drawings.

Implementation 1

As shown in FIG. 5, the compensation element 13 may include a diode 131, an anode of the diode 131 is connected to the fourth electrode T4 of the current sampling element 12, and a cathode of the diode 131 is connected to the second electrode T2 of the power element 11. In this embodiment of this application, the current sampling element 12 has the positive temperature coefficient, and the diode 131 may have the negative temperature coefficient. Therefore, the diode 131 may compensate for the deviation between the sampling values of the current sampling element 12 at the different temperatures, so that the sampling values output by the current sampling element 12 in sampling the same current at the different temperatures are the same or similar.

Implementation 2

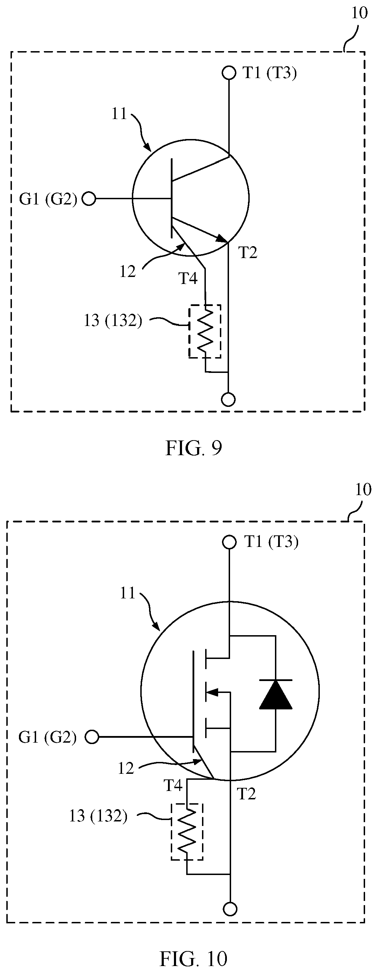

FIG. 9 is a diagram of another structure of the power device according to this embodiment of this application. In FIG. 9, an example in which the power element is an IGBT is used for illustration. FIG. 10 is a diagram of another structure of the power device according to this embodiment of this application. In FIG. 10, an example in which the power element is a MOSFET is used for illustration. As shown in FIG. 9 and FIG. 10, the compensation element 13 may include a resistor 132, one end of the resistor 132 is connected to the fourth electrode T4 of the current sampling element 12, and the other end of the resistor is connected to the second electrode T2 of the power element 11. In this embodiment of this application, the current sampling element 12 has the positive temperature coefficient, and the resistor 132 may have the negative temperature coefficient. Therefore, the resistor 132 may compensate for the deviation between the sampling values of the current sampling element 12 at the different temperatures, so that the sampling values output by the current sampling element 12 in sampling the same current at the different temperatures are the same or similar.

In FIG. 9 and FIG. 10, an example in which the resistor 132, the power element 11, and the current sampling element 12 are located in the same wafer 10 is used for illustration. During specific implementation, the resistor 132 may alternatively be located at a location outside the wafer 10 in which the power element 11 and the current sampling element 12 are located. Details are not described herein again.

Implementation 3

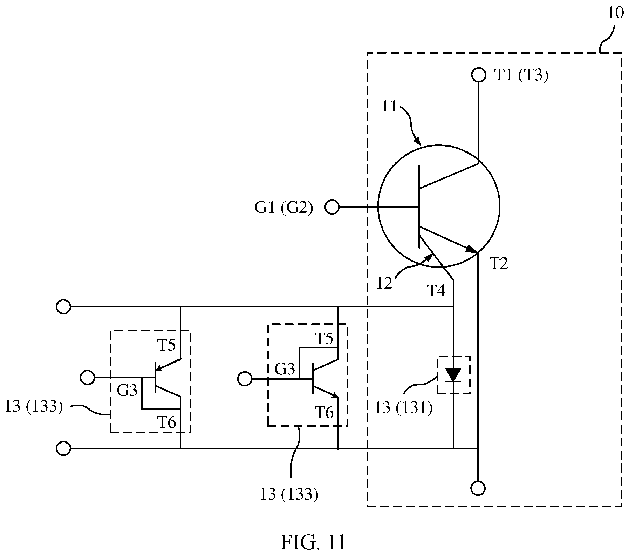

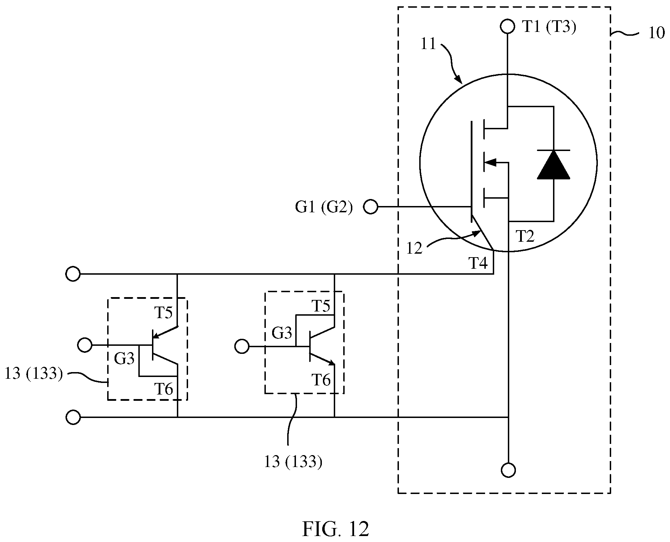

FIG. 11 is a diagram of another structure of the power device according to this embodiment of this application. In FIG. 11, an example in which the power element is an IGBT is used for illustration. FIG. 12 is a diagram of another structure of the power device according to this embodiment of this application. In FIG. 12, an example in which the power element is a MOSFET is used for illustration. As shown in FIG. 11 and FIG. 12, the compensation element 13 may include a triode 133, the triode 133 may include a third control end G3, a fifth electrode T5, and a sixth electrode T6, the third control end G3 of the triode 133 is connected to the fifth electrode T5 or the sixth electrode T6, the fifth electrode T5 of the triode 133 is connected to the fourth electrode T4 of the current sampling element 12, and the sixth electrode T6 of the triode 133 is connected to the second electrode T2 of the power element 11.

In FIG. 11 and FIG. 12, the triode 133 on the left is used as an example. The triode 133 may be a PNP transistor, and the third control end G3 may be connected to the sixth electrode T6, so that the triode 133 is equivalent to a diode. In FIG. 11 and FIG. 12, the triode 133 on the right is used as an example. The triode 133 may be an NPN transistor, and the third control end G3 may be connected to the fifth electrode T5, so that the triode 133 is equivalent to a diode. To illustrate structures of the PNP transistor and the NPN transistor, in FIG. 11 and FIG. 12, an example in which the power device includes one PNP transistor and one NPN transistor is used for illustration. During specific implementation, the power device may include only one triode 133, or may include two or more triodes 133; and may include only one type of transistor, or may include two types of transistors. A quantity and a type of triodes 133 are not limited herein.

In this embodiment of this application, the current sampling element 12 has the positive temperature coefficient, and the triode 133 may have the negative temperature coefficient by using a carrier life control method. Therefore, the triode 133 may compensate for the deviation between the sampling values of the current sampling element 12 at the different temperatures, so that the sampling values output by the current sampling element 12 in sampling the same current at the different temperatures are the same or similar.

For example, the triode 133 may be a bipolar junction transistor (BJT). Certainly, the triode 133 may alternatively be another triode having a negative temperature coefficient. This is not limited herein.

Several implementations for the compensation element are described above. During specific implementation, the several implementations may be combined, that is, the power device may include different types of compensation elements. For example, in FIG. 11, the power device may include the diode 131 and the triode 133. In some embodiments, in addition to the several implementations described above, the compensation element may also be another element whose temperature coefficient is opposite to that of the current sampling element. This is not limited herein.

In this embodiment of this application, as shown in FIG. 5, the compensation element 13 in the power device may be disposed only inside the wafer 10. Alternatively, as shown in FIG. 7, the compensation element 13 in the power device may be disposed only outside the wafer 10. Alternatively, as shown in FIG. 11, when the power device includes at least two compensation elements 13, the compensation elements 13 may be disposed respectively inside and outside the wafer 10. During specific implementation, a quantity and locations of compensation elements 13 may be set based on internal spatial layout and a compensation requirement of the power device. This is not limited herein.

Based on a same technical concept, an embodiment of this application further provides an electronic device. The electronic device may include any one of the foregoing power devices and a drive chip. The drive chip is configured to: receive a sampling value output by a current sampling element, and perform a corresponding protection operation when the sampling value exceeds a specified threshold.

The electronic device may be used in a vehicle such as an electric vehicle, or the electronic device may be used in a scenario with a high-power requirement, such as a photovoltaic charging station, a charging station, or a charging pile. In addition, the electronic device may be another device including a power device. This is not limited herein. For example, the electronic device in this embodiment of this application may be a power module, and the power may include any one of the foregoing power devices, a peripheral drive chip, a heat dissipation device, a package device, and the like.

A compensation element connected in series to the current sampling element is disposed in the foregoing power device, a temperature coefficient of the current sampling element is opposite to that of the compensation element, and the compensation element may compensate for a deviation between sampling values of the current sampling element at different temperatures, so that sampling values output by the current sampling element in sampling a same current at the different temperatures are the same or similar, and precision of the sampling values output by the current sampling element is high. In addition, threshold currents of a power element used when overcurrent protection or short-circuit protection is triggered at different temperatures are the same or similar, and a large trigger threshold does not need to be set in the drive chip. This can prevent an overcurrent protection operation or a short-circuit protection operation from being triggered by mistake at a low temperature, and can reduce a current value of the power element used when overcurrent protection or short-circuit protection is triggered, thereby reducing voltage stress of the power element generated when overcurrent protection or short-circuit protection is triggered, reducing a turn-off resistance or a gate capacitance, reducing a turn-off loss, and improving a current output capability of the power device.

During specific implementation, a trigger threshold in the drive chip may be classified into a first threshold and a second threshold. The first threshold is used to trigger overcurrent protection, and the second threshold is used to trigger short-circuit protection. Generally, the first threshold is less than the second threshold. The drive chip may compare the sampling value output by the current sampling element with the first threshold and the second threshold. When the sampling value is greater than the first threshold and less than the second threshold, the drive chip may trigger overcurrent protection such as stopping sending the PWM driver gating signal. When the sampling value is greater than the second threshold, the drive chip may trigger short-circuit protection such as soft shutdown.

Based on a same technical concept, an embodiment of this application further provides a circuit structure. The circuit structure may be used in a power electronic device with a high-power requirement, such as a vehicle-mounted inverter or a photovoltaic inverter.

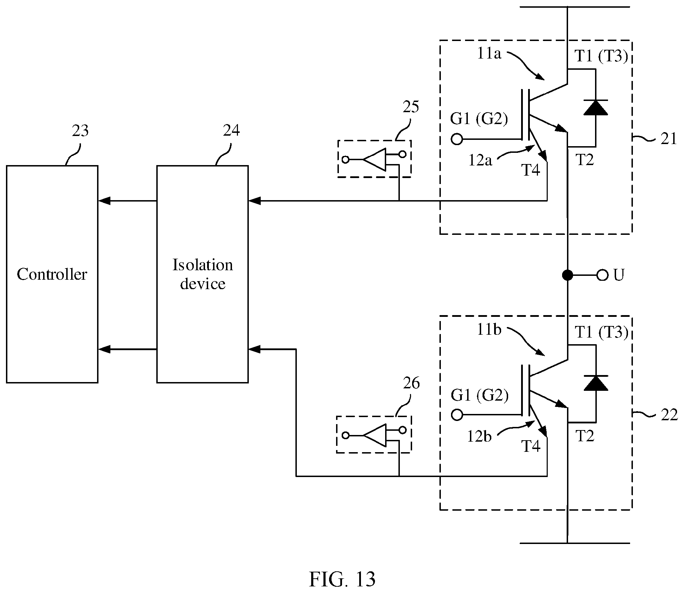

FIG. 13 is a schematic of a circuit structure according to an embodiment of this application. As shown in FIG. 13, the circuit structure may include at least one bridge arm, a controller 23, and a first output end U. The at least one bridge arm may include an upper bridge arm and a lower bridge arm, the upper bridge arm may include at least one first power device 21, the lower bridge arm may include at least one second power device 22, and the first power device 21 and the second power device 22 each are any one of the foregoing power devices. The first power device 21 may include a first power element 11a, a first current sampling element 12a, and a first compensation element (not shown in the figure). The first current sampling element 12a is connected in series to the first compensation element, and the first compensation element may compensate for a deviation between sampling values of the first current sampling element 12a at different temperatures, so that sampling values output by the first current sampling element 12a in sampling a same current at the different temperatures are the same or similar. The second power device 22 may include a second power element 11b, a second current sampling element 12b, and a second compensation element (not shown in the figure). The second current sampling element 12b is connected in series to the second compensation element, and the second compensation element may compensate for a deviation between sampling values of the second current sampling element 12b at different temperatures, so that sampling values output by the second current sampling element 12b in sampling a same current at the different temperatures are the same or similar. That is, current sampling precision of the first current sampling element 12a and the second current sampling element 12b in this embodiment of this application is high.

The first power element 11a and the second power element 11b are separately connected to the first output end U, the first current sampling element 12a and the second current sampling element 12b are separately connected to the controller 23, and the controller 23 is configured to determine a current value and phase information of the first output end U based on first sampling information output by the first current sampling element 12a and second sampling information output by the second current sampling element 12b. The first sampling information may include a sampling value, the second sampling information may include a sampling value, and the sampling value may be a voltage of a sampling resistor, or may be another parameter.

In the conventional technology, a Hall current sensor is usually connected to a first output end U, to detect a current value and phase information of the first output end U. However, the Hall current sensor has a large volume, and a response speed of the Hall current sensor is low, and is generally about 10 μs. In this embodiment of this application, the current value and the phase information of the first output end U may be determined based on the first sampling information output by the first current sampling element 12a and the second sampling information output by the second current sampling element 12b, to replace a function of the Hall current sensor in the conventional technology, that is, the Hall current sensor does not need to be disposed at the first output end U. This can simplify the circuit structure, reduce an overall volume of the circuit structure, and increase power density. In addition, in this embodiment of this application, a response speed for detecting a current by the current sampling element is high. For example, the response speed may be less than 1 μs. This can effectively increase the response speed for current detection, and improve performance of the circuit structure.

In a possible implementation, the circuit structure in this embodiment of this application may further include an isolation device 24. The first power device 21 and the second power device 22 are connected to the controller 23 via the isolation device 24. Ground signals of the controller 23 and the first power device 21 (or the second power device 22) may be different, and the isolation device 24 may play an insulation and isolation role.

During specific implementation, the circuit structure in this embodiment of this application may further include a first protection device 25 connected to the first power device 21 and a second protection device 26 connected to the second power device 22. The first protection device 25 may have an overcurrent protection function. When the sampling value output by the first current sampling element 12a is greater than a first threshold and less than a second threshold, the first protection device 25 may play an overcurrent protection role. Alternatively, the first protection device 25 may have a short-circuit protection function. When the sampling value output by the first current sampling element 12a is greater than a second threshold, the first protection device 25 may play a short-circuit protection role. Similarly, the second protection device 26 may have an overcurrent protection function. When the sampling value output by the second current sampling element 12b is greater than the first threshold and less than the second threshold, the second protection device 26 may play an overcurrent protection role. Alternatively, the second protection device 26 may have a short-circuit protection function. When the sampling value output by the second current sampling element 12b is greater than the second threshold, the second protection device 26 may play a short-circuit protection role.

For example, the circuit structure in this embodiment of this application may be used in an inverter. Generally, the inverter has three phases of current, and the first output end U in FIG. 13 may output one phase of current. During specific implementation, a manner similar to that in FIG. 13 may also be used, and current sampling elements are disposed in the power device, to detect current values and phase information of the other two phases of currents.

Although some preferred embodiments of this application have been described, persons skilled in the art can make changes and modifications to these embodiments once they learn of a basic inventive concept. Therefore, the following claims are intended to be construed as to cover the preferred embodiments and all changes and modifications falling within the scope of this application.

Clearly, persons skilled in the art can make various modifications and variations to embodiments of this application without departing from the spirit and scope of embodiments of this application. In this way, this application is intended to cover these modifications and variations of embodiments of this application provided that they fall within the scope of protection defined by the following claims and their equivalent technologies.

## Claims

1. A power device, comprising a power element, a current sampling element, and a compensation element, wherein

   the power element comprises a first control end, a first electrode, and a second electrode;
   the current sampling element is configured to detect a current value between the first electrode and the second electrode of the power element, the current sampling element comprises a second control end, a third electrode, and a fourth electrode, the second control end is connected to the first control end, the third electrode is connected to the first electrode, and the fourth electrode is connected to the second electrode via the compensation element; and
   the current sampling element is connected in series to the compensation element, and a temperature coefficient of the current sampling element is opposite to that of the compensation element.

2. The power device according to claim 1, wherein the current sampling element samples a current of the power element based on a specified ratio.

3. The power device according to claim 1 or 2, wherein the power device comprises one compensation element or at least two compensation elements connected in series and/or in parallel.

4. The power device according to claim 3, wherein the compensation element comprises a diode; and an anode of the diode is connected to the fourth electrode of the current sampling element, and a cathode of the diode is connected to the second electrode of the power element.

5. The power device according to claim 3, wherein the compensation element comprises a resistor; and one end of the resistor is connected to the fourth electrode of the current sampling element, and the other end of the resistor is connected to the second electrode of the power element.

6. The power device according to claim 3, wherein the compensation element comprises a triode; and the triode comprises a third control end, a fifth electrode, and a sixth electrode, the third control end of the triode is connected to the fifth electrode or the sixth electrode, the fifth electrode of the triode is connected to the fourth electrode of the current sampling element, and the sixth electrode of the triode is connected to the second electrode of the power element.

7. The power device according to any one of claims 1 to 6, wherein the power element, the current sampling element, and the compensation element are located in a same wafer.

8. The power device according to any one of claims 1 to 6, wherein the power element and the current sampling element are located in a same wafer, the compensation element is located at a location outside the wafer, and the compensation element is located on a side that is of the power element and that is close to the first control end.

9. The power device according to any one of claims 1 to 8, wherein the power element comprises an insulated gate bipolar transistor or a metal-oxide semiconductor field-effect transistor.

10. An electronic device, comprising the power device according to any one of claims 1 to 9 and a drive chip, wherein
    the drive chip is configured to: receive a sampling value output by the current sampling element, and perform a corresponding protection operation when the sampling value exceeds a specified threshold.

11. A circuit structure, comprising at least one bridge arm, a controller, and a first output end, wherein

    the at least one bridge arm comprises an upper bridge arm and a lower bridge arm;
    the upper bridge arm comprises at least one first power device, the lower bridge arm comprises at least one second power device, and the first power device and the second power device each are the power device according to any one of claims 1 to 9;
    the first power device comprises a first power element, a first current sampling element, and a first compensation element, and the second power device comprises a second power element, a second current sampling element, and a second compensation element;
    the first power element and the second power element are separately connected to the first output end, and the first current sampling element and the second current sampling element are separately connected to the controller; and
    the controller is configured to determine a current value and phase information of the first output end based on first sampling information output by the first current sampling element and second sampling information output by the second current sampling element.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

## INTERNATIONAL SEARCH REPORT

| International application No. |
| --- |
| **PCT/CN2023/112355** |

**A. CLASSIFICATION OF SUBJECT MATTER**

H03K17/14(2006.01)i

According to International Patent Classification (IPC) or to both national classification and IPC

**B. FIELDS SEARCHED**

Minimum documentation searched (classification system followed by classification symbols)

IPC: H03K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 温度, 系数, 电流, 温漂, 热敏, 温敏, PTC, 特性, 准确, 补偿, 相反, 反向, 电阻, 二极管, 三极管, 正, 负, 采样, 电流, 采集, 感测, 测量, 传感, temperature, coefficient, current, drift, heat, sensitive, characteristic, accurate, compensation, reverse, resistance, diode, triode, positive, negative, sampl+, collect+, sens +, measure+

**C. DOCUMENTS CONSIDERED TO BE RELEVANT**

| Category* | Citation of document, with indication, where appropriate, of the relevant passages | Relevant to claim No. |
| --- | --- | --- |
| PX | CN 115549664 A (HUAWEI DIGITAL POWER TECHNOLOGIES CO., LTD.) 30 December 2022 (2022-12-30)<br>claims 1-11 | 1-11 |
| X | CN 105137160 A (INFINEON TECHNOLOGIES AG) 09 December 2015 (2015-12-09)<br>description, paragraphs 16-65, and figures 1-5 | 1-11 |
| A | CN 1212506 A (NEC CORP.) 31 March 1999 (1999-03-31)<br>entire document | 1-11 |
| A | CN 108696102 A (FORD GLOBAL TECHNOLOGIES, LLC) 23 October 2018 (2018-10-23)<br>entire document | 1-11 |
| A | US 2002140498 A1 (STMICROELECTRONICS S.R.L.) 03 October 2002 (2002-10-03)<br>entire document | 1-11 |

| ☐ Further documents are listed in the continuation of Box C. | ☑ See patent family annex. |
| --- | --- |

\*    Special categories of cited documents:
"A"   document defining the general state of the art which is not considered to be of particular relevance
"D"   document cited by the applicant in the international application
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search | Date of mailing of the international search report |
| --- | --- |
| **24 October 2023** | **31 October 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/112355**

| Patent document cited in search report | | | Publication date (day/month/year) | Patent family member(s) | | | Publication date (day/month/year) |
|---|---|---|---|---|---|---|---|
| CN | 115549664 | A | 30 December 2022 | None | | | |
| CN | 105137160 | A | 09 December 2015 | US | 2015346245 | A1 | 03 December 2015 |
| | | | | US | 9513318 | B2 | 06 December 2016 |
| | | | | DE | 102015108410 | A1 | 03 December 2015 |
| CN | 1212506 | A | 31 March 1999 | JPH | 1197942 | A | 09 April 1999 |
| | | | | JP | 3166678 | B2 | 14 May 2001 |
| | | | | US | 6118327 | A | 12 September 2000 |
| | | | | KR | 19990029942 | A | 26 April 1999 |
| | | | | KR | 100310882 | B1 | 15 November 2001 |
| | | | | CN | 1114262 | C | 09 July 2003 |
| CN | 108696102 | A | 23 October 2018 | US | 2018281600 | A1 | 04 October 2018 |
| | | | | US | 10611246 | B2 | 07 April 2020 |
| | | | | DE | 102018107178 | A1 | 04 October 2018 |
| US | 2002140498 | A1 | 03 October 2002 | ITMI | 20002806 | A1 | 22 June 2002 |
| | | | | IT | 1319613 | B1 | 20 October 2003 |
| | | | | US | 6552602 | B2 | 22 April 2003 |

Form PCT/ISA/210 (patent family annex) (July 2022)

## REFERENCES CITED IN THE DESCRIPTION

**Patent documents cited in the description**

- CN 202211131954